# EUROPEAN PATENT APPLICATION

(11) **EP 3 229 260 A1**
(43) Date of publication of application: **11.10.2017**
(21) Application number: 15864392.4
(22) Date of filing: 22.10.2015
(51) Int. Cl.: H01L 21/02, H01L 21/265, H01L 27/12

(54) **COMPOSITE SUBSTRATE MANUFACTURING METHOD AND COMPOSITE SUBSTRATE**

(30) Priority: 05.12.2014 JP 2014246797
(71) Applicant: Shin-Etsu Chemical Co., Ltd., Tokyo 100-0004 (JP)
(72) Inventor: AKIYAMA Shoji, Annaka-shi Gunma 379-0195 (JP)
(74) Representative: Vossius & Partner Patentanwälte Rechtsanwälte mbB
(86) International application number: PCT/JP2015/079763
(87) International publication number: WO 2016/088466

(57) **Abstract**

To provide a composite substrate whereby a nanocarbon film having no defect can be manufactured at low cost.

A method for manufacturing a composite substrate, including: implanting ion from a surface of a single crystal silicon carbide substrate to form an ion-implanted region; bonding an ion-implanted surface of the single crystal silicon carbide substrate and a main surface of a handle substrate, and peeling the single crystal silicon carbide substrate at the ion-implantedregion to transfer a single crystal silicon carbide thin film onto the handle substrate, wherein the surface to be bonded of the single crystal silicon carbide substrate and the surface to be bonded of the handle substrate each has a surface roughness RMS of 1.00 nm or less.

## Description

### Technical Field

The present invention relates to a method for manufacturing a composite substrate, and specifically relates to a method for manufacturing a composite substrate by which a nanocarbon film can be manufactured at high quality and low cost, and a composite substrate manufactured by said manufacturing method.

### Background Art

In recent years, nanocarbons represented by graphene, fullerene and carbon nanotubes gain attention as novel materials for electronic devices. For example, due to extremely high mobility (it is said to be 100 times as large as the mobility of silicon), higher durability than that of steel iron, and the like possessed by graphene, studies on graphene as a platform for next-generation electronic devices have been progressed.

Some suggestions have been made as methods for forming a nanocarbon, and for example, a sublimation process is exemplified. This is a method such that single crystal silicon carbide (SiC) is treated in an inert gas at a high temperature to allow the silicon (Si) in the silicon carbide to evaporate, and the residual carbon (C) forms graphene (JP 2007-335532 A (Patent Literature 1)). This method is a method that attracts lots of attention in recent years as a method in which a graphene wafer can be obtained from a single crystal silicon carbide wafer (diameter: 6 inches at the maximum). Furthermore, also for fullerene and carbon nanotubes, it is possible that a high quality film is formed by using a single crystal silicon carbide as a platform substrate.

However, there is a problem that the cost increases by using a single crystal silicon carbide wafer, which is very expensive. Specifically, the price of a semi-insulating single crystal silicon carbide wafer, which seems important for use in electronic devices, is about several ten thousands yen for even one wafer having a diameter of about three inches, and thus the semi-insulating single crystal silicon carbide wafer has a disadvantage that it is too expensive to be used extensively.

Examples of the prior art relating to the present invention include WO 2014/061337 (Patent Literature 2).

### Prior Art References

### Patent Document

Patent Literature 1: JP 2007-335532 A
Patent Literature 2: WO 2014/061337 A

### Summary of Invention

### Problems to be solved by the Invention

The present invention has been made in view of the above-mentioned situation, and aims at providing a method for manufacturing a composite substrate by which a nanocarbon film having no defect can be manufactured at low cost, and a composite substrate manufactured by said manufacturing method.

### Means for solving the Problems

In order to solve this problem, the present inventors have invented the following method. Specifically, since it is sufficient that a single crystal silicon carbide layer that is converted to graphene generally has a thickness of several layers of atoms and thus a thick silicon carbide layer is unnecessary, a single crystal silicon carbide thin film is obtained by transferring a thin film of single crystal silicon carbide to a support wafer (handle wafer) . Specifically, a single crystal silicon carbide wafer in which hydrogen ion has been implanted in advance is bonded to a support wafer to thereby obtain a sufficient bonding strength, and peeling is then conducted on an ion-implanted interface. At this time, the surface of the single crystal silicon carbide substrate and the surface of the handle substrate to be bonded are respectively smoothened to improve the tight bonding strength of the bonding. By this way, many single crystal silicon carbide thin films can be transferred from one single crystal silicon carbide wafer, and the advantage in cost is extremely increased.

That is, the present invention provides the method for manufacturing a composite substrate and the composite substrate mentioned below.
[1] A method for manufacturing a composite substrate, including: implanting ion from a surface of a single crystal silicon carbide substrate to form an ion-implanted region; bonding an ion-implanted surface (hereinafter referred to as "ion-implanted surface") of the single crystal silicon carbide substrate and a main surface of a handle substrate, and peeling the single crystal silicon carbide substrate at the ion-implanted region to transfer a single crystal silicon carbide thin film onto the handle substrate, wherein the surface to be bonded of the single crystal silicon carbide substrate and the surface to be bonded of the handle substrate each has a surface roughness RMS of 1.00 nm or less.
[2] The method for manufacturing a composite substrate according to [1], wherein the handle substrate is formed of a heat resistant material having a heat resistance temperature of 1,100°C or more (except for single crystal silicon carbide).
[3] The method for manufacturing a composite substrate according to [1] or [2], wherein the handle substrate is formed of an amorphous silicon carbide or a polycrystalline silicon carbide.
[4] The method for manufacturing a composite substrate according to any one of [1] to [3], including forming a thin film formed of at least one kind of material selected from silicon oxide, silicon nitride, aluminum oxide, aluminum nitride, zirconiumoxide, silicon and silicon carbide on the ion-implanted surface of the single crystal silicon carbide substrate and/or the main surface of the handle substrate; and polishing the thin film to thereby adjust the surface roughness RMS of the surface of the thin film to 1.00 nm or less.
[5] The method for manufacturing a composite substrate according to any one of [1] to [3], including forming a thin film formed of at least one kind of metal material selected from Ti, Au, Ag, Cu, Ni, Co, Fe, Cr, Zr, Mo, Ta and W on the ion-implanted surface of the single crystal silicon carbide substrate and/or the main surface of the handle substrate; and adjusting the a surface roughness RMS of the surface of the thin film to 1.00 nm or less.
[6] The method for manufacturing a composite substrate according to any one of [1] to [5], including subjecting the surface to be bonded of the silicon carbide substrate and/or the surface to be bonded of the handle substrate to a surface activation treatment, and conducting the bonding.
[7] The method for manufacturing a composite substrate according to [6], wherein the surface activation treatment is a plasma activation treatment, a vacuum ion beam treatment or an immersion treatment in ozone water.
[8] The method for manufacturing a composite substrate according to any one of [1] to [7], including bonding the single crystal silicon carbide substrate and the handle substrate, and applying a physical impact to the ion-implanted region to thereby peel the single crystal silicon carbide substrate.
[9] A composite substrate obtained by the method for manufacturing a composite substrate according to any one of [1] to [8].
[10] The composite substrate according to [9], wherein the composite substrate is for forming a nanocarbon film.

### Advantageous Effects of Invention

According to the present invention, since bonding is conducted by using a single crystal silicon carbide substrate and a handle substrate whose surfaces to be bonded have predetermined smoothness, during a peeling treatment at an ion-implanted interface, which is conducted after the bonding, a single crystal silicon carbide thin film can be transferred without peeling at the bonding interface between the single crystal silicon carbide substrate and the handle substrate. Specifically, a substrate formed of silicon carbide has a very high hardness, and thus it is difficult to smoothen the surface by polishing. By forming a specific thin film on the surface of the substrate, it becomes easy to smoothen the surface, and thus fine tight-adhesion strength can be obtained in the above-mentioned bonding. Furthermore,bysubjectingthesingle crystal silicon carbide film to thin-film transfer to the handle substrate, it becomes unnecessary to prepare many single crystal silicon carbide substrates, which are expensive, and thus a composite substrate from which a nanocarbon film can be prepared at low costs can be provided.

### Brief Description of the Drawings

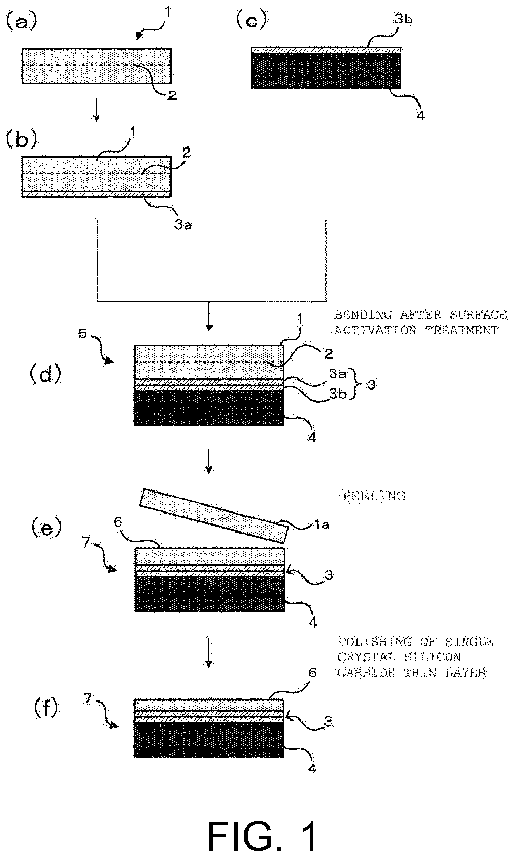

Figs. 1(a) to 1(f) are schematic views showing the manufacture steps in the first exemplary embodiment in the method for manufacturing a composite substrate of the present invention, wherein Fig. 1(a) is a cross-sectional view of an ion-implanted single crystal silicon carbide substrate, Fig. 1(b) is a cross-sectional view showing a state in which a thin film has been formed on the ion-implanted surface of the single crystal silicon carbide substrate, Fig. 1(c) is a cross-sectional view showing a state that a thin film has been formed on one main surface of a handle substrate, Fig. 1(d) is a cross-sectional view showing a state that the single crystal silicon carbide substrate and the handle substrate are bonded, Fig. 1(e) is a cross-sectional view showing a state that the single crystal silicon carbide substrate has been peeled at the ion-implanted region, and Fig. 1(f) is a cross-sectional view of a composite substrate.

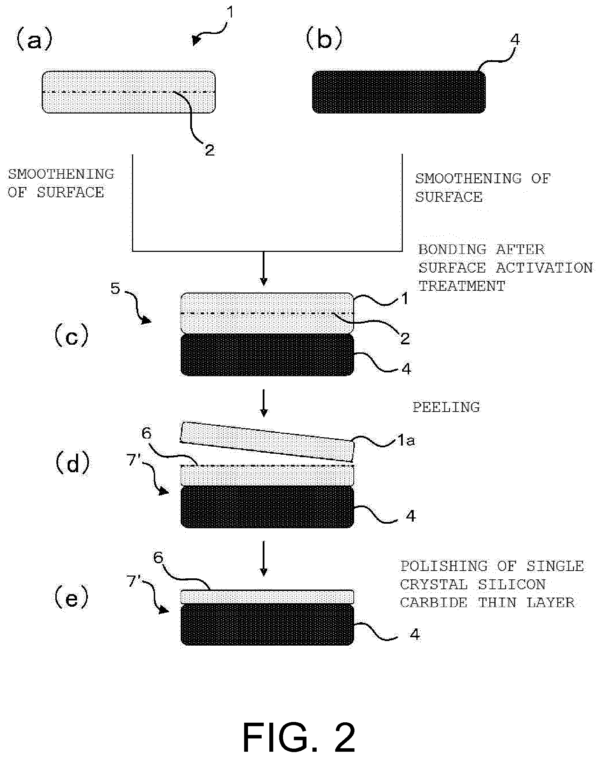

Figs. 2(a) to 2(e) are schematic views showing the manufacture steps in the second exemplary embodiment of the method for manufacturing a composite substrate according to the present invention, wherein Fig. 2 (a) is a cross-sectional view of an ion-implant single crystal silicon carbide substrate in which the ion-implanted surface has been smoothened, Fig. 2 (b) is a cross-sectional view of a handle substrate in which one main surface has been smoothened, Fig. 2 (c) is a cross-sectional view showing a state that the single crystal silicon carbide substrate and the handle substrate are bonded, Fig. 2(d) is a cross-sectional view showing a state that the single crystal silicon carbide substrate has been peeled at the ion-implanted region, and Fig. 2 (e) is a cross-sectional view of a composite substrate.

### Description of Embodiments

The exemplary embodiments of the method for manufacturing a composite substrate and the composite substrate will be explained below.

### (First exemplary embodiment)

As shown in Figs. 1(a) to 1(f), in the method for manufacturing a composite substrate according to the first exemplary embodiment of the present invention, treatments are conducted in the following order:
a step of implanting hydrogen ion in a single crystal silicon carbide substrate (Step 1),
a step of smoothening an ion-implanted surface of the single crystal silicon carbide substrate (Step 2),
a step of smoothening a handle substrate (Step 3),
a step of a surface activation treatment of the single crystal silicon carbide substrate and/or the handle substrate (Step 4),
a step of bonding the single crystal silicon carbide substrate and the handle substrate (Step 5),
a step of peeling treatment (Step 6), and
a step of polishing a single crystal silicon carbide thin film (Step 7).

### (Step 1: step of implanting hydrogen ion in single crystal silicon carbide substrate)

Firstly, hydrogen ion or the like is implanted in a single crystal silicon carbide substrate 1 to form an ion-implanted region 2 (Fig. 1(a)).

The single crystal silicon carbide substrate 1 that is bonded to the handle substrate 4 herein is preferably selected from single crystal silicon carbide substrates having crystal structures of 4H-SiC, 6H-SiC and 3C-SiC. The size of the single crystal silicon carbide substrate 1 and the size of a handle substrate 4 mentioned below are set based on the necessary size, cost and the like of a nanocarbon film. Furthermore, the thickness of the single crystal silicon carbide substrate 1 is a thickness in the vicinity of the substrate thickness of the SEMI specification or JEIDA specification in view of handling. As the single crystal silicon carbide substrate 1, a commercially available single crystal silicon carbide substrate such as a commercially available single crystal silicon carbide wafer for power devices can be used, and it is preferable to use a single crystal silicon carbide substrate having a plane and smooth surface, wherein said surface has been finally polished by a CMP (Chemical Mechanical Polishing (or Planarization)) treatment.

During the implantation of ion into the single crystal silicon carbide substrate 1, at least hydrogen ion (H⁺) or hydrogen molecule ion (H₂⁺) at a predetermined dose is implanted at implantation energy such that the ion-implanted region 2 can be formed at a desired depth from the surface of the substrate. As the condition at this time, the ion implantation energy may be set so as to give a desired thickness of a thin film. He ion, B ion and the like may be simultaneously implanted, and any ion may be adopted as long as a similar effect can be obtained.

The ion implantation depth corresponds to a desired thickness of the single crystal silicon carbide thin film.

The dose amount of the hydrogen ion (H⁺) implanted in the single crystal silicon carbide substrate 1 is preferably from 1.0 × 10¹⁶ atom/cm² to 9.0 × 10¹⁷ atom/cm². When the dose amount is lower than 1.0 × 10¹⁶ atom/cm², the embrittlement of the interface does not occur in some cases, whereas when the dose amount goes beyond 9.0 × 10¹⁷ atom/cm², air bubbles are formed during the heat treatment after the bonding, and thus transfer deficiency occurs in some cases.

In the case when hydrogen molecule ion (H₂⁺) is used as the implant ion, the dose amount thereof is preferably 5.0 × 10¹⁵ atoms/cm² to 4.5 × 10¹⁷ atoms/cm². When the dose amount is lower than 5.0 × 10¹⁵ atoms/cm², the embrittlement of the interface does not occur in some cases, whereas when the dose amount goes beyond 4.5 × 10¹⁷ atoms/cm², air bubbles are formed during the heat treatment after the bonding, and thus transfer deficiency occurs in some cases.

The depth from the ion-implanted surface of the substrate to the ion-implanted region 2 (i.e., ion implantation depth) corresponds to a desired thickness of a single crystal silicon carbide thin film 6 to be disposed on the handle substrate 4, and is generally from 100 to 2,000 nm, preferably from 300 to 500 nm, further preferably about 400 nm. Furthermore, the thickness of the ion-implanted region 2 (i.e., ion distribution thickness) is preferably a thickness that enables easy peeling by a mechanical impact or the like, and is preferably from 200 to 400 nm, further preferably about 300 nm.

Furthermore, it is also possible to form an insulating film such as a silicon oxide film of about 50 to 500 nm in advance on the surface of the single crystal silicon carbide substrate 1, and implant hydrogen ion or hydrogen molecule ion through the insulating film. By this way, an effect to suppress the channeling of the implanted ion can be obtained.

### (Step 2: step of smoothening ion-implanted surface of single crystal silicon carbide substrate (Fig. 1(b))

In the present invention, the surface of the single crystal silicon carbide substrate 1 to be bonded (the ion-implanted surface) is formed into a smooth surface having a surface roughness RMS of 1.00 nm or less. In this case, it is also possible to conduct the smoothening by directly polishing the surface of the single crystal silicon carbide substrate 1, but it is not easy to polish the very hard substrate formed of silicon carbide. Therefore, in this step, the surface of the single crystal silicon carbide substrate 1 is smoothened by conducting either of Steps 2-1 and 2-2 mentioned below.

### (Step 2-1)

A thin film 3a having heat resistance against a heat treatment, which is conducted later, and being formed of a material having a heat expansion coefficient that is identical with or close to the heat expansion coefficient of a finally formed single crystal silicon carbide thin film 6 is formed on the ion-implanted surface of the single crystal silicon carbide substrate 1. Examples of the material for constituting the thin film 3a include at least one kind of material selected from silicon oxide (for example, SiO₂), silicon nitride, aluminum nitride, silicon (for example, amorphous silicon, polycrystalline silicon), alumina (Al₂O₃), zirconium oxides (for example, zirconia (ZrO₂)) and silicon carbides (for example, amorphous silicon carbide and polycrystalline silicon carbide). In the case when plural materials are selected from these materials, the thin film 3a may have either a structure in which those materials are respectively laminated or a single layer structure formed of a material in which those materials are mixed.

The film thickness of the thin film 3a is preferably from 1 to 200 nm, more preferably from 1 to 100 nm, further preferably from 1 to 20 nm. If this film thickness is lower than 1 nm, it is possible that the surface is not covered completely due to the unevenness of the film thickness in the surface, and thus the tight-adhesiveness of the bonding with the handle substrate 4 is deteriorated. Furthermore, at greater than 200 nm, it is possible that the surface roughness of the deposited thin film 3a is deteriorated, and thus a desired smoothness cannot be obtained even by polishing. In addition, it is necessary to adjust the thickness of the formed film to a film thickness with consideration for the thickness of the polishing that is subsequently conducted after this step.

The method for forming the thin film 3a may be any method as long as it is a film-forming method by which the thin film 3a can be formed on the single crystal silicon carbide substrate 1 with fine tight adhesiveness. For example, it is preferable that a thin film of silicon oxide is formed by a PECVD process and thin films of silicon nitride, aluminum nitride, silicon and silicon carbide are formed by a sputtering process.

Subsequently, the thin film 3a is polished to thereby set the surface roughness RMS of the surface thereof to 1.00 nm or less, preferably 0.80 nm or less, more preferably 0.70 nm or less. When the surface roughness RMS of the thin film 3a is greater than 1.00 nm, peeling occurs at a bonding interface with the handle substrate 4 (i.e., an interface with the thin film 3b) during a peeling treatment for forming a single crystal silicon carbide thin film, which is conducted later, or in the subsequent heat treatment. The surface roughness RMS (Root-mean-square: square mean roughness) means a square mean root roughness as referred to in Rq JIS B0601: 2013.

The method for polishing the thin film 3a is preferably a chemical mechanical polishing process, and the conditions therefor differ depending on the materials of the thin film 3a.

### (Step 2-2)

A thin film 3a formed of a metal material having a melting point of 950°C or more, for example, at least one kind of metal material selected from Ti, Au, Ag, Cu, Ni, Co, Fe, Cr, Zr, Mo, Ta and W, on the ion-implanted surface of the single crystal silicon carbide substrate 1. By using the metal material having a melting point of 950°C or more, the thin film 3a can be prevented from melting during a low temperature heat treatment in the subsequent peeling treatment step. Furthermore, in the case when plural metal materials are selected from these metal materials, the thin film may have either of a structure in which those metal materials are respectively laminated, or a single layer structure formed of an alloy material of those metal materials.

The film thickness of the thin film 3a is set to preferably from 1 to 100 nm, more preferably from 1 to 20 nm, further preferably from 1 to 10 nm. When this film thickness is lower than 1 nm, it is possible that the surface of the substrate is not covered completely due to the unevenness of the film thickness in the surface, and thus the tight adhesiveness of the bonding with the handle substrate 4 is deteriorated. Alternatively, when this film thickness is greater than 100 nm, it is possible that the surface roughness of the thin film 3a is deteriorated, and thus the tight adhesiveness of the bonding with the handle substrate 4 is deteriorated.

The method for forming the thin film 3a may be any method as long as it is a film formation method by which a film can be formed with fine tight adhesiveness on the single crystal silicon carbide substrate 1. For example, it is preferable to form the thin film 3a by an electron beam deposition process.

In the present Step 2-2, by only forming the thin film 3a by the deposition of the above-mentioned metal material (s) (i.e., without polishing), the surface roughness RMS of the surface thereof can be adjusted to 1.00 nm or less, preferably 0.80 nm or less, more preferably 0.75 nm or less. When the surface roughness RMS of the thin film 3a is greater than 1.00 nm, peeling occurs at a bonding interface with the handle substrate 4 (i.e., an interface with the thin film 3b), during a peeling treatment for forming a single crystal silicon carbide thin film, which is conducted later, or in the subsequent heat treatment.

It is also possible to change the order of the above-mentioned Steps 1 and 2 to thereby form the thin film 3a first on the surface of the single crystal silicon carbide substrate 1, and then conduct the above-mentioned ion implantation from the above of the thin film 3a.

### (Step 3: step of smoothening handle substrate (Fig. 1(c))

As the handle substrate 4 used in the present invention, a handle substrate formed of a heat resistant material having a heat resistance temperature of 1,100°C or more (except for single crystal silicon carbide) is preferable, and for example, handle substrates formed of silicon carbides that are not single crystals, i.e., amorphous silicon carbide and polycrystalline silicon carbide, or quartz glass, sapphire, crystalline silicon (single crystal silicon and polycrystalline silicon), silicon nitride, diamond or aluminum nitride can be used. Among those, handle substrates formed of amorphous silicon carbide or polycrystalline silicon carbide, which has a heat expansion coefficient that is close to that of single crystal silicon carbide and has heat resistance against a heat treatment conducted later are more preferable. By using a heat resistant material having a heat resistance temperature of 1, 100°C or more, the substrate can be prevented from damaging by the heating treatment in the subsequent step of polishing a single crystal silicon carbide thin film. Furthermore, although the thickness of the handle substrate 4 is not specifically limited, a thickness in the vicinity of the general SEMI specification or JEIDA specification is preferable in view of handling, as in the single crystal silicon carbide substrate 1.

A thin film 3b formed of a material that has heat resistance against a heat treatment that is conducted later, and has a heat expansion coefficient that is identical with or close to the heat expansion coefficient of the single crystal silicon carbide thin film 6, is formed on at least a surface to be bonded to the single crystal silicon carbide substrate 1 of the handle substrate 4 to thereby smoothen the surface of the handle substrate 4. A similar treatment to that in the above-mentioned Step 2-1 or 2-2 is conducted here.

Specifically, the treatment corresponding to Step 2-1 is conducted as shown below.

First, the thin film 3b formed of at least one kind of material selected from silicon oxides (for example, SiO₂), silicon nitride, aluminum nitride, silicon (for example, amorphous silicon, polycrystalline silicon), alumina (Al₂O₃), zirconium oxides (for example, zirconia (ZrO₂)) and silicon carbides (for example, amorphous silicon carbide, polycrystalline silicon carbide) on a surface to be bonded with the single crystal silicon carbide substrate 1 of the handle substrate 4. In the case when plural materials are selected from these materials, the thin film 3b may have either a structure in which those materials are respectively laminated or a single layer structure formed of a material in which those materials are mixed.

The film thickness of the thin film 3b in this case is preferably from 1 to 200 nm, more preferably from 1 to 100 nm, further preferably from 1 to 20 nm. If this film thickness is lower than 1 nm, it is possible that the surface is not covered completely due to the unevenness of the film thickness in the surface, and thus the tight-adhesiveness of the bonding with the single crystal silicon carbide substrate 1 is deteriorated. Furthermore, at greater than 200 nm, it is possible that the surface roughness of the deposited thin film 3b is deteriorated, and thus a desired smoothness cannot be obtained even by polishing. In addition, it is necessary to adjust the thickness of the formed film to a film thickness with consideration for the thickness of the polishing that is subsequently conducted after this step.

The method for forming the thin film 3b may be any method as long as it is a film-forming method by which the thin film 3b can be formed on the handle substrate 4 with fine tight adhesiveness, and for example, it is preferable that a thin film of silicon oxide is formed by a PECVD process and thin films of silicon nitride, aluminum nitride, silicon, alumina, zirconium oxides and silicon carbide are formed by a sputtering process.

Subsequently, the thin film 3b is polished to thereby set the surface roughness RMS of the surface thereof to 1.00 nm or less, preferably 0.80 nm or less, more preferably 0.70 nm or less. When the surface roughness RMS of the thin film 3b is greater than 1.00 nm, peeling occurs at a bonding interface with the single crystal silicon carbide substrate 1 (i.e., an interface with the thin film 3a), during a peeling treatment for forming a single crystal silicon carbide thin film, which is conducted later, or in the subsequent heat treatment.

The method for polishing the thin film 3b is preferably a chemical mechanical polishing process, and the conditions therefor differ depending on the materials of the thin film 3b.

Furthermore, the treatment corresponding to Step 2-2 is conducted as follows.

A thin film 3b formed of at least one kind of metal material selected from metal materials having a melting point of 950°C or more such as Ti, Au, Ag, Cu, Ni, Co, Fe, Cr, Zr, Mo, Ta and W is formed on a surface to be bonded (main surface) to be bonded with the single crystal silicon carbide substrate 1 of the handle substrate 4. By using the metal material(s) having a melting point of 950°C or more, the thin film 3a can be prevented from melting in a low temperature heat treatment in the subsequent step of a peeling treatment. Furthermore, in the case when plural metal materials are selected from these metal materials, the thin film may have either of a structure in which those metal materials are respectively laminated, or a single layer structure formed of an alloy material of those metal materials.

The film thickness of the thin film 3b in this case is set to preferably from 1 to 100 nm, more preferably from 1 to 20 nm, further preferably from 1 to 10 nm. When this film thickness is lower than 1 nm, it is possible that the surface of the substrate is not covered completely due to the unevenness of the film thickness in the surface, and thus the tight adhesiveness of the bonding with the single crystal silicon carbide substrate 1 is deteriorated. Alternatively, when this film thickness is greater than 100 nm, it is possible that the surface roughness of the thin film 3b is deteriorated, and thus the tight adhesiveness of the bonding with the single crystal silicon carbide substrate 1 is deteriorated.

The method for forming the thin film 3b may be any method as long as it is a film formation method by which a film can be formed with fine tight adhesiveness on the handle substrate 4. For example, it is preferable to form the thin film 3b by an electron beam deposition process.

In this treatment, by only forming the thin film 3b by the deposition of the above-mentioned metal material (s) (i.e., without polishing), the surface roughness RMS of the surface thereof can be adjusted to 1.00 nm or less, preferably 0.80 nm or less, more preferably 0.75 nm or less. When the surface roughness RMS of the thin film 3b is greater than 1.00 nm, peeling occurs at a bonding interface with the single crystal silicon carbide substrate 1 (i.e., an interface with the thin film 3a), during a peeling treatment for forming a single crystal silicon carbide thin film, which is conducted later, or in the subsequent heat treatment.

In addition, it is preferable to use the same material as the constitutional material of the above-mentioned thin film 3a as the material for constituting the thin film 3b, since the tight adhesiveness of the bonding is improved. Furthermore, it is preferable to set the surface roughnesses of the thin films 3a and 3b to be within a certain range (for example, the difference of the surface roughnesses is within ±0.05 nm in surface roughness RMS), since the tight adhesiveness of the bonding is further improved.

### (Step 4: step of surface activation treatment of single crystal silicon carbide substrate and/or handle substrate)

Subsequently, the surface of the single crystal silicon carbide substrate 1 and the surface of the handle substrate 4 to be bonded, i.e., the surfaces of the thin films 3a and 3b, are subjected to a plasma activation treatment, a vacuum ion beam treatment or an immersion treatment in ozone water as a surface activation treatment.

Among these, in the case when the plasma activation treatment is conducted, the single crystal silicon carbide substrate 1 and/or the handle substrate 4 that has/have undergone the treatments up to the above-mentioned Step 3 is/are placed in a vacuum chamber, a plasma gas is introduced under a reduced pressure, then the substrate(s) is/are exposed to a high-frequency wave at about 100 W for about 5 to 10 seconds, to thereby subject the surface(s) to a plasma activation treatment. As the plasma gas, an oxygen gas, a hydrogen gas, a nitrogen gas, an argon gas or a mixed gas thereof, or a mixed gas of a hydrogen gas and a helium gas can be used.

In the vacuum ion beam treatment, the single crystal silicon carbide substrate 1 and/or the handle substrate 4 is/are placed in a high-vacuum chamber, and the surface (s) to be bonded is/are irradiated with an ion beam such as Ar to thereby conduct an activation treatment.

In the immersion treatment in ozone water, the single crystal silicon carbide substrate 1 and/or the handle substrate 4 is/are immersed in ozone water in which an ozone gas is dissolved to thereby conduct an activation treatment on the surface(s).

The above-mentioned surface activation treatments may be conducted on either only the single crystal silicon carbide substrate 1 or the handle substrate 4, but it is more preferable to conduct the surface activation treatment on both of the single crystal silicon carbide substrate 1 and the handle substrate 4.

Furthermore, the surface activation treatment may be either one of the above-mentioned methods, or a combined treatment may be conducted. Furthermore, the surface of the single crystal silicon carbide substrate 1 and the surface of the handle substrate 4 to be subjected to the surface activation treatment are preferably the surfaces of the thin films 3a and 3b, which are the surfaces to be bonded.

### (Step 5: step of bonding single crystal silicon carbide substrate and handle substrate)

Then, the surface of the single crystal silicon carbide substrate 1 and the surface of the handle substrate 4 which have undergone the surface activation treatment (the surfaces of the thin films 3a and 3b) are bonded as joint surfaces (Fig. 1(d)).

Then, after the bonding of the single crystal silicon carbide substrate 1 and the handle substrate 4, a heat treatment at preferably from 150 to 350°C, more preferably from 150 to 250°C is conducted, whereby the bonding strength on the bonded surfaces of the thin films 3a and 3b is improved. At lower than 150°C, a sufficient bond strength cannot be obtained, whereas at greater than 350°C, peeling due to the difference in heat expansion coefficients easily generates at the initial stage of the heat treatment (= at the stage before the bond strength is sufficiently increased) . During the heat treatment, warpage of the substrate is generated by the difference in heat expansion rates between the single crystal silicon carbide substrate 1 and the handle substrate 4, but the warpage may be suppressed by adopting temperatures that are suitable for the respective materials. The time for the heat treatment is preferably from 2 to 24 hours depending on the temperature to some extent.

By this way, the thin film 3a and the thin film 3b are tightly bonded to form one layer, an intermediate layer 3, and the single crystal silicon carbide substrate 1 and the handle substrate 4 are strongly and tightly bonded via the intermediate layer 3 to form a bonded substrate 5.

### (Step 6: step of peeling treatment)

After the single crystal silicon carbide substrate 1 and the handle substrate 4 have been bonded and the bonding strength has been improved, a thermal energy or a mechanical energy is applied to the ion-implanted part to peel the single crystal silicon carbide substrate 1a at the ion-implanted region 2, whereby a composite substrate 7 having a single crystal silicon carbide thin film 6 on the handle substrate 4 is prepared (Fig. 1(e)).

As the peeling process, for example, a heat peeling process in which the bonded substrate 5 is heated to a high temperature, and a fine bubble body of the ion-implanted component is generated in the ion-implanted region 2 by this heat to thereby separate the single crystal silicon carbide substrate 1a, can be applied. Alternatively, a mechanical peeling process in which the single crystal silicon carbide substrate 1a is separated by mechanically generating peeling by applying a physical impact to one end of the ion-implanted region 2 while conducting a heat treatment at a low temperature such that heat peeling does not occur (for example, from 500 to 900°C, preferably from 500 to 700°C) can be applied. The mechanical peeling process is more preferable since the roughness of a transfer surface after the transfer of the single crystal silicon carbide thin film is relatively smaller than that in the heat peeling process.

In addition, after the peeling treatment, a heat treatment for improving the tight adhesiveness between the single crystal silicon carbide thin film 6 and the handle substrate 4 may be conducted by heating the composite substrate 7 under conditions of a temperature that is a heating temperature of from 700 to 1,000°C and higher than the temperature during the peeling treatment, and a heating time of from 1 to 24 hours.

At this time, the thin film 3a and the thin film 3b are strongly tight-bonded, and further, the thin film 3a and the single crystal silicon carbide substrate 1 are strongly tight-bonded, and the thin film 3b and the handle substrate 4 are strongly tight-bonded. Therefore, peeling on the parts other than the peeling part on the ion-implanted region 2 does not occur.

By subjecting again the surface of the single crystal silicon carbide substrate 1a after peeling to polishing, washing or the like, the single crystal silicon carbide substrate 1a can be reused as a substrate for bonding in said method for manufacturing a composite substrate.

### (Step 7: step of polishing single crystal silicon carbide thin film)

The surface of the single crystal silicon carbide thin film 6 on the handle substrate 4 is subjected to mirror surface finishing (Fig. 1(f)). Specifically, the single crystal silicon carbide thin film 6 is subjected to chemical mechanical polishing (CMP polishing) to shape the surface into a mirror surface. The polishing herein may be conventionally-known CMP polishing that is used in the planarization of silicon wafers, and the like.

The composite substrate 7 obtained as above can be used for forming a nanocarbon film, specifically, for forming a nanocarbon film on the handle substrate 4 (intermediate layer 3) by sublimating silicon atoms from the single crystal silicon carbide thin film 6 by heating. Specifically, by heating the composite substrate 7 to preferably 1,100°C or more, more preferably from 1,200 to 1,400°C, further preferably to 1,250 to 1,350°C, the silicon atoms (Si) in the single crystal silicon carbide thin film 6 are sublimated, whereby a nanocarbon film having a thickness of about from 50 to 1, 500 nm can be formed. It is preferable to set the atmosphere of this heating treatment to a vacuum atmosphere (reduced pressure) since silicon atoms are easily sublimated. Furthermore, since the temperature condition at this time is changed depending on the atmosphere, the number of sheets to be treated, and the like, the temperature is suitably set to an optimal temperature.

The nanocarbon film after the sublimation has a structure in which fullerene, graphene or carbon nanotube, or a mixture of two or more kinds selected from those is present, depending on the conditions for the preparation of the nanocarbon film, and the like. The structure may be suitably selected depending on use.

In this exemplary embodiment, the formation of the thin film 3a in Step 2, or the formation of the thin film 3b in Step 3 may be omitted. In the case when the thin film 3a is omitted, the ion-implanted surface of the single crystal silicon carbide substrate 1 is polished so as to have a surface roughness RMS of 1.00 nm or less. Alternatively, in the case when the thin film 3b is omitted, the surface of the handle substrate 4 to be bonded with the single crystal silicon carbide substrate 1 is polished so as to have a surface roughness RMS of 1.00 nm or less.

### (Second exemplary embodiment)

Figs. 2 (a) to 2 (e) show a drawing of the manufacture steps in the method for manufacturing a composite substrate according to the second exemplary embodiment of the present invention. In this exemplary embodiment, the steps are similar to those of the first exemplary embodiment except that the thin films 3a and 3b are not formed, and the treatments are conducted by the following order: a step of implanting hydrogen ion in a single crystal silicon carbide substrate (Step 1) ; a step of smoothening the ion-implanted surface of the single crystal silicon carbide substrate (Step 2); a step of smoothening a handle substrate (Step 3) ; a step of subjecting the single crystal silicon carbide substrate and/or the handle substrate to a surface activation treatment (Step 4) ; a step of bonding the single crystal silicon carbide substrate and the handle substrate (Step 5) ; a step of a peeling treatment (Step 6) ; and a step of polishing the single crystal silicon carbide thin film (Step 7). The single crystal silicon carbide substrate 1, ion-implanted region 2 and handle substrate 4 are the same as those in the first exemplary embodiment.

### (Step 1: step of implanting hydrogen ion in single crystal silicon carbide substrate)

Firstly, hydrogen ion or the like is implanted in a single crystal silicon carbide substrate 1 to form an ion-implanted region 2 (Fig. 2 (a)). This step is the same as that in the first exemplary embodiment.

### (Step 2: step of smoothening ion-implanted surface of single crystal silicon carbide substrate)

In this step, the surface to be bonded (ion-implanted surface) with a handle substrate 4 of the single crystal silicon carbide substrate 1 shown in Fig. 2 (a) is formed into a smooth surface having a surface roughness RMS of 1.00 nm or less. In this case, a single crystal silicon carbide wafer of a commercially available product having a surface roughness RMS of 1.00 nm or less may be prepared, or the surface may be formed into a smooth surface having a surface roughness RMS of 1.00 nm or less by subjecting the surface to a CMP treatment after the ion-implanting treatment.

### (Step 3: step of smoothening handle substrate)

Also in this step, the surface to be bonded with the single crystal silicon carbide substrate 1 of the handle substrate 4 shown in Fig. 2 (b) is formed into a smooth surface having a surface roughness RMS of 1.00 nm or less. Also in this case, a commercially available product having a surface roughness RMS of 1.00 nm or less may be prepared as a handle substrate, or the surface may be formed into a smooth surface having a surface roughness RMS of 1.00 nm or less by subjecting the surface to a CMP treatment.

### (Step 4: step of surface activation treatment of single crystal silicon carbide substrate and/or handle substrate)

Subsequently, the surface of the single crystal silicon carbide substrate 1 and the surface of the handle substrate 4 to be bonded are subjected to a plasma activation treatment, a vacuum ion beam treatment or an immersion treatment in ozone water as a surface activation treatment. The conditions for the treatment, and the like are the same as those in the first exemplary embodiment.

### (Step 5: step of bonding single crystal silicon carbide substrate and handle substrate)

The surface of the single crystal silicon carbide substrate 1 and the surface of the handle substrate 4 which have undergone the surface activation treatment are bonded as joint surfaces (Fig. 2(c)).

Then, after the bonding of the single crystal silicon carbide substrate 1 and the handle substrate 4, a heat treatment at preferably from 150 to 350°C, more preferably from 150 to 250°C is conducted, whereby the bonding strength on the bonded surfaces is improved. At lower than 150°C, a sufficient bond strength cannot be obtained, whereas at greater than 350°C, peeling due to the difference in heat expansion coefficients easily generates at the initial stage of the heat treatment (= at the stage before the bond strength is sufficiently increased) . During the heat treatment, warpage of the substrate is generated by the difference in heat expansion rates between the single crystal silicon carbide substrate 1 and the handle substrate 4, but the warpage may be suppressed by adopting temperatures that are suitable for the respective materials. The time for the heat treatment is preferably from 2 to 24 hours depending on the temperature to some extent.

By this way, a bonded substrate 5 in which the single crystal silicon carbide substrate 1 and the handle substrate 4 are tightly attached directly and strongly is formed.

### (Step 6: step of peeling treatment)

A thermal energy or a mechanical energy is imparted to the ion-implanted part of the bonded substrate 5 to peel the single crystal silicon carbide substrate 1a at the ion-implanted region 2, whereby a composite substrate 7'having the single crystal silicon carbide thin film 6 on the handle substrate 4 is prepared (Fig. 2(d)). The peeling process is the same that in the first exemplary embodiment.

At this time, the single crystal silicon carbide substrate 1 and the handle substrate 4 are strongly tight-attached. Therefore, peeling on the parts other than the peeling part in the ion-implanted region 2 is not generated.

### (Step 7: step of polishing single crystal silicon carbide thin film)

The surface of the single crystal silicon carbide thin film 6 on the handle substrate 4 is subjected to mirror surface finishing (Fig. 2(e)).

### Examples

The presentinvention willbespecifically explained below with referring to Examples and Comparative Examples. However, the present invention is not limited to Examples.

The surface roughness RMS was obtained by an atomic force microscope (AFM) by measuring the surface of the substrate. The measurement condition was a measurement region of 10 µm × 10 µm.

### [Example 1]

As the single crystal silicon carbide substrate 1, a single crystal silicon carbide wafer having a diameter of 3 inch (Polytype 4H, thickness 400 µm) of a commercially available product was prepared, and hydrogen ion (H⁺) was implanted in this single crystal silicon carbide wafer at 100 KeV and a dose amount of 8.8 × 10¹⁶ atom/cm². The surface of this single crystal silicon carbide wafer had been finished by a CMP treatment, and had a surface roughness RMS of 0.90 nm.

Subsequently, as the handle substrate 4, a polycrystalline silicon carbide wafer having a diameter of 3 inch (thickness: 400 µm) was prepared, and a silicon oxide (SiO₂) thin film having a thickness of 100 nm was formed as a thin film 3b on the main surface by a PECVD process, and this thin film was polished by a CMP treatment. The surface roughness RMS was 0.60 nm.

Subsequently, the ion-implanted surface of the single crystal silicon carbide substrate and the thin film-formed surface of the handle substrate were subjected to a plasma activation surface treatment, and the surfaces were bonded. At this time, the bonded substrates were subjected to a heat treatment at 150°C for 5 hours to give a joined body.

Subsequently, when this joined body was set in a boat and heated in a heating furnace to 950°C, heat peeling occurred at the ion-implanted region, whereby a composite substrate in which the single crystal silicon carbide thin film had been homogeneously transferred to the polycrystalline silicon carbide wafer through the silicon oxide thin film was obtained (the result of the peeling was fine). That "the single crystal silicon carbide thin film had been homogeneously transferred", means that peeling was not occur on the laminated part other than the ion-implanted region according to visual observation.

The surface of the composite substrate to which the single crystal silicon carbide thin film had been transferred had a surface roughness RMS of 8.2 nm.

### [Example 2]

Using the following two kinds of handle substrates in the method for manufacturing a composite substrate of the present invention, and using a mechanical peeling process as the peeling process, a composite substrate was prepared as follows.

### (Example 2-1)

As the single crystal silicon carbide substrate 1, a single crystal silicon carbide wafer having a diameter of 3 inch (Polytype 4H, thickness 400 µm) of a commercially available product was prepared, and hydrogen ion (H⁺) was implanted in this single crystal silicon carbide wafer at 100 KeV and a dose amount of 8.8 × 10¹⁶ atom/cm². The surface of this single crystal silicon carbide wafer had been finished by a CMP treatment, and had a surface roughness RMS of 0.90 nm.

Subsequently, as the handle substrate 4, apolycrystalline silicon carbide wafer having a diameter of 3 inch (thickness: 400 µm) was prepared, and a silicon oxide (SiO₂) thin film having a thickness of 100 nm was formed as a thin film 3b on the main surface by a PECVD process, and this thin film was polished by a CMP treatment. The surface roughness RMS was 0.60 nm.

Subsequently, the ion-implanted surface of the single crystal silicon carbide substrate and the thin film-formed surface of the handle substrate were subjected to a plasma activation surface treatment, and the surfaces were bonded. At this time, the bonded substrates were subjected to a heat treatment at 150°C for 5 hours to give a joined body.

Subsequently, this joined body was set in a boat and heated to 880°C, as a low temperature heat treatment to the extent that heat peeling does not occur, in a heating furnace. When a mechanical impact was imparted to one end of the ion-implanted region after the heating treatment time for 30 minutes hadpassed, mechanical peeling occurred at the ion-implanted region, whereby a composite substrate in which the single crystal silicon carbide thin film had been homogeneously transferred to the polycrystalline silicon carbide wafer via a silicon oxide thin film was obtained (the result of the peeling was fine).

The surface to which the single crystal silicon carbide thin film had been transferred of the composite substrate had a surface roughness RMS of 4.7 nm.

### (Example 2-2)

A composite substrate was prepared in a similar manner to that of Example 2-1, except that the handle substrate 4 was changed to an amorphous silicon carbide wafer having a diameter of 3 inch (thickness: 400 µm) in Example 2-1.

As a result, a composite substrate in which the single crystal silicon carbide thin film had been homogeneously transferred to the amorphous silicon carbide wafer via a silicon oxide thin film was obtained (the result of the peeling was fine). The surface roughness after the CMP treatment of the thin film-formed surface of the handle substrate 4 was 0.60 nm, and the surface roughness RMS of the surface to which the single crystal silicon carbide thin film had been transferred of the composite substrate was 5.1 nm.

As mentioned above, the surface roughness of the surface to which the single crystal silicon carbide thin film has been transferred of the composite substrate can be decreased by using a mechanical peeling process as the peeling process, and thus it is possible to alleviate the burden for subjecting this transferred surface to mirror surface finishing.

### [Example 3]

In the method for manufacturing a composite substrate of the present invention, six kinds of thin films 3a and 3b were formed on the single crystal silicon carbide substrate 1 and the handle substrate 4, respectively, to thereby smoothen the surface, and the composite substrate was prepared as follows.

### (Example 3-1)

As the single crystal silicon carbide substrate 1, a single crystal silicon carbide wafer having a diameter of 3 inch (Polytype 4H, thickness 400 µm) of a commercially available product was prepared, and hydrogen ion (H⁺) was implanted in this single crystal silicon carbide wafer at 100 KeV and a dose amount of 8.8 × 10¹⁶ atom/cm².

Subsequently, a silicon oxide (SiO₂) thin film having a thickness of 100 nm was formed as the thin film 3a on the ion-implanted surface of the single crystal silicon carbide substrate 1 by a PECVD process, and this thin film was polished by a CMP treatment. The surface roughness RMS was 0.60 nm.

Subsequently, as the handle substrate 4, a polycrystalline silicon carbide wafer having a diameter of 3 inch (thickness: 400 µm) was prepared, and a silicon oxide (SiO₂) thin film having a thickness of 100 nm was formed as a thin film 3b on the main surface by a PECVD process, and this thin film was polished by a CMP treatment. The surface roughness RMS was 0.60 nm.

Subsequently, the thin film-formed surface of the single crystal silicon carbide substrate and the thin film-formed surface of the handle substrate were subjected to a plasma activation surface treatment, and the surfaces were bonded. At this time, the bonded substrates were subjected to a heat treatment at 150°C for 5 hours to give a joined body.

Subsequently, this joined body was set in a boat and heated to 880°C, as a low temperature heat treatment to the extent that heat peeling does not occur, in a heating furnace. When a mechanical impact was imparted to one end of the ion-implanted region after the heating treatment time for 30 minutes hadpassed, mechanical peeling occurred at the ion-implanted region, whereby a composite substrate in which the single crystal silicon carbide thin film had been homogeneously transferred to the polycrystalline silicon carbide wafer via a silicon oxide thin film was obtained (the result of the peeling was fine).

### (Example 3-2)

A composite substrate was prepared in a similar manner to that of Example 3-1, except that silicon nitride (SiN) thin films each having a thickness 100 nm were respectively formed as thin films 3a and 3b by a sputtering process, and then these thin films are finished by polishing by a CMP treatment in Example 3-1.

As a result, a composite substrate in which the single crystal silicon carbide thin film had been homogeneously transferred to the polycrystalline silicon carbide wafer via a silicon nitride thin film was obtained (the result of the peeling was fine). The surface roughnesses of the thin film-formed surfaces of the single crystal silicon carbide substrate 1 and the handle substrate 4 after the CMP treatment were respectively 0.63 nm.

### (Example 3-3)

A composite substrate was prepared in a similar manner to that of Example 3-1, except that amorphous silicon carbide (SiC) thin films each having a thickness of 100 nm were respectively formed as thin films 3a and 3b by a sputtering process, and these thin films were finished by polishing by a CMP treatment in Example 3-1.

As a result, a composite substrate in which the single crystal silicon carbide thin film had been homogeneously transferred to the polycrystalline silicon carbide wafer via a silicon oxide thin film was obtained (the result of the peeling was fine). The surface roughnesses of the thin film-formed surfaces of the single crystal silicon carbide substrate 1 and the handle substrate 4 after the CMP treatment were respectively 0.68 nm.

### (Example 3-4)

A composite substrate was prepared in a similar manner to that of Example 3-1, except that amorphous silicon (Si) thin films each having a thickness of 100 nm were respectively formed as thin films 3a and 3b by a sputtering process, and these thin films were finished by polishing by a CMP treatment in Example 3-1.

As a result, a composite substrate in which the single crystal silicon carbide thin film had been homogeneously transferred to the polycrystalline silicon carbide wafer via a silicon oxide thin film was obtained (the result of the peeling was fine). The surface roughnesses of the thin film-formed surfaces of the single crystal silicon carbide substrate 1 and the handle substrate 4 after the CMP treatment were respectively 0.65 nm.

### (Example 3-5)

A composite substrate was prepared in a similar manner to that of Example 3-1, except that thin titanium (Ti) thin films having a thickness of 20 nm were respectively formed as thin films 3a and 3b respectively by an electron beam deposition process, and were directly used without subjecting to a CMP treatment in Example 3-1.

As a result, a composite substrate in which the single crystal silicon carbide thin film had been homogeneously transferred to the polycrystalline silicon carbide wafer via a silicon oxide thin film was obtained (the result of the peeling was fine). The surface roughnesses of the thin film-formed surfaces of the single crystal silicon carbide substrate 1 and the handle substrate 4 were respectively 0.71 nm.

### (Example 3-6)

A composite substrate was prepared in a similar manner to that of Example 3-1, except that a titanium (Ti) thin film having a thickness of 20 nm and a gold (Au) thin film having a thickness of 20 nm were respectively formed by an electron beam deposition process as the thin films 3a and 3b, and the thin films were directly used without subjecting to a CMP treatment in Example 3-1.

As a result, a composite substrate in which the single crystal silicon carbide thin film had been homogeneously transferred to the polycrystalline silicon carbide wafer via a laminated thin film of the titanium thin films and the gold thin films (a thin film having a four-layer structure of Ti/Au/Au/Ti) was obtained (the result of the peeling was fine). The surface roughnesses of the thin film-formed surfaces of the single crystal silicon carbide substrate 1 and the handle substrate 4 were respectively 0.75 nm.

### [Example 4]

A composite substrate was prepared in a similar manner to that of Example 3, except that the handle substrate 4 was changed to an amorphous silicon carbide wafer having a diameter of 3 inch (thickness: 400 µm) in Example 3. The details are as follows.

### (Example 4-1)

A composite substrate was prepared in a similar manner to that of Example 3-1, except that the handle substrate 4 was changed to an amorphous silicon carbide wafer (thickness: 400 µm) having a diameter of 3 inch in Example 3-1.

As a result, a composite substrate in which the single crystal silicon carbide thin film had been homogeneously transferred to the amorphous silicon carbide wafer via a silicon oxide thin film was obtained (the result of the peeling was fine) . The surface roughnesses of the thin film-formed surfaces of the single crystal silicon carbide substrate 1 and the handle substrate 4 after the CMP treatment were respectively 0.60 nm.

### (Example 4-2)

A composite substrate was prepared in a similar manner to that of Example 3-2, except that the handle substrate 4 was changed to an amorphous silicon carbide wafer (thickness: 400 µm) having a diameter of 3 inch in Example 3-2.

As a result, a composite substrate in which the single crystal silicon carbide thin film had been homogeneously transferred to the amorphous silicon carbide wafer via a silicon nitride thin film was obtained (the result of the peeling was fine). The surface roughnesses of the thin film-formed surfaces of the single crystal silicon carbide substrate 1 and the handle substrate 4 after the CMP treatment were respectively 0.63 nm.

### (Example 4-3)

A composite substrate was prepared in a similar manner to that of Example 3-3, except that the handle substrate 4 was changed to an amorphous silicon carbide wafer having a diameter of 3 inch (thickness: 400 µm) in Example 3-3.

As a result, a composite substrate in which the single crystal silicon carbide thin film had been homogeneously transferred to the amorphous silicon carbide wafer via a silicon carbide thin film was obtained (the result of the peeling was fine). The surface roughnesses of the thin film-formed surfaces of the single crystal silicon carbide substrate 1 and the handle substrate 4 after the CMP treatment were respectively 0.68 nm.

### (Example 4-4)

A composite substrate was prepared in a similar manner to that of Example 3-4, except that the handle substrate 4 was changed to an amorphous silicon carbide wafer having a diameter of 3 inch (thickness: 400 µm) in Example 3-4.

As a result, a composite substrate in which the single crystal silicon carbide thin film had been homogeneously transferred to the amorphous silicon carbide wafer via a silicon thin film was obtained (the result of the peeling was fine). The surface roughnesses of the thin film-formed surfaces of the single crystal silicon carbide substrate 1 and the handle substrate 4 after the CMP treatment were respectively 0.65 nm.

### (Example 4-5)

A composite substrate was prepared in a similar manner to that of Example 3-5, except that the handle substrate 4 was changed to an amorphous silicon carbide wafer having a diameter of 3 inch (thickness: 400 µm) in Example 3-5.

As a result, a composite substrate in which the single crystal silicon carbide thin film had been homogeneously transferred to the amorphous silicon carbide wafer via a titanium thin film was obtained (the result of the peeling was fine). The surface roughnesses of the thin film-formed surfaces of the single crystal silicon carbide substrate 1 and the handle substrate 4 were respectively 0.71 nm.

### (Example 4-6)

A composite substrate was prepared in a similar manner to that of Example 3-6, except that the handle substrate 4 was changed to an amorphous silicon carbide wafer having a diameter of 3 inch (thickness: 400 µm) in Example 3-6.

As a result, a composite substrate in which the single crystal silicon carbide thin film had been homogeneously transferred to the amorphous silicon carbide wafer via a laminated thin film of the titanium thin films and the gold thin films (a thin film having a four-layer structure of Ti/Au/Au/Ti) was obtained (the result of the peeling was fine). The surface roughnesses of the thin film-formed surfaces of the single crystal silicon carbide substrate 1 and the handle substrate 4 were respectively 0.75 nm.

### [Example 5]

In the method for manufacturing a composite substrate of the second exemplary embodiment of the present invention, the conditions for the surface activation treatment before the bonding were changed, and a composite substrate was prepared as follows.

### (Example 5-1)

As the single crystal silicon carbide substrate 1, a single crystal silicon carbide wafer having a diameter of 3 inch (Polytype 4H, thickness 400 µm) of a commercially available product was prepared, and hydrogen ion (H⁺) was implanted in this single crystal silicon carbide wafer at 100 KeV and a dose amount of 8.8 × 10¹⁶ atom/cm². This single crystal silicon carbide wafer had a surface finished by a CMP treatment, and the surface had a surface roughness RMS of 0.90 nm.

Subsequently, as the handle substrate 4, a polycrystalline silicon carbide wafer having a diameter of 3 inch (thickness: 400 µm) was prepared. This polycrystalline silicon carbide wafer had a surface finished by a CMP treatment, and the surface had a surface roughness RMS of 0.95 nm.

Subsequently, the ion-implanted surface of the single crystal silicon carbide substrate and the surface to be bonded of the handle substrate were subjected to a plasma activation surface treatment, and these surfaces were bonded. Subsequently, the bonded substrates were subjected to a heat treatment at 150°C for 5 hours to give a joined body.

Subsequently, this joined body was set in a boat and heated to 880°C, as a low temperature heat treatment to the extent that heat peeling does not occur, in a heating furnace. When a mechanical impact was imparted to one end of the ion-implanted region after the heating treatment time for 30 minutes hadpassed, mechanical peeling occurred at the ion-implanted region, whereby a composite substrate in which the single crystal silicon carbide thin film had been homogeneously transferred to the polycrystalline silicon carbide wafer was obtained (the result of the peeling was fine).

### (Example 5-2)

A composite substrate was prepared in a similar manner to that of Example 5-1, except that the ion-implanted surface of the single crystal silicon carbide substrate and the surface to be bonded of the handle substrate were subjected to a vacuum ion beam treatment as a surface activation treatment before bonding in Example 5-1. The vacuum ion beam treatment was conducted by irradiating the surfaces with Ar ion.

As a result, a composite substrate in which the single crystal silicon carbide thin film had been homogeneously transferred to the polycrystalline silicon carbide wafer was obtained (the result of the peeling was fine).

### (Example 5-3)

A composite substrate was prepared in a similar manner to that of Example 5-1, except that the ion-implanted surface of the single crystal silicon carbide substrate and the surface to be bonded of the handle substrate were subjected to an immersion treatment by ozone water as a surface activation treatment before bonding in Example 5-1. The immersion treatment by ozone water was conducted by immersing the substrates in a container containing ultrapure water containing ozone for 10 minutes.

As a result, a composite substrate in which the single crystal silicon carbide thin film had been homogeneously transferred to the polycrystalline silicon carbide wafer was obtained (the result of the peeling was fine).

### (Example 5-4)

A composite substrate was prepared in a similar manner to that of Example 5-1, except that the substrates were not treated, i.e., the surface activation treatment before bonding was not conducted, in Example 5-1.

As a result, in the obtained composite substrate, peeling of the single crystal silicon carbide thin film from the polycrystalline silicon carbide wafer generated on a part (by a surface area of about 5%) according to visual observation, but the major part of the single crystal silicon carbide thin filmhadbeen transferred to the polycrystalline silicon carbide wafer with fine tight adhesiveness. Therefore, the composite substrate was in a state that the composite substrate could be used for the formation of a nanocarbon film form.

### [Comparative Example 1]

In the method for manufacturing a composite substrate of the second exemplary embodiment of the present invention, the conditions for the surface activation treatment before the bonding were changed, and a composite substrate was prepared as follows.

### (Comparative Example 1-1)

As the single crystal silicon carbide substrate 1, a single crystal silicon carbide wafer having a diameter of 3 inch (Polytype 4H, thickness 400 µm) of a commercially available product was prepared, and hydrogen ion (H⁺) was implanted in this single crystal silicon carbide wafer at 100 KeV and a dose amount of 8.8 × 10¹⁶ atom/cm².

This single crystal silicon carbide wafer had a surface finished by a CMP treatment, and the surface had a surface roughness RMS of 0.95 nm.

Subsequently, as the handle substrate 4, a polycrystalline silicon carbide wafer having a diameter of 3 inch (thickness: 400 µm) was prepared. This polycrystalline silicon carbide wafer had a surface finished by a CMP treatment, and the surface had a surface roughness RMS of 1.05 nm.

Subsequently, the ion-implanted surface of the single crystal silicon carbide substrate and the surface to be bonded of the handle substrate were subjected to a plasma activation surface treatment, and these surfaces were bonded. Subsequently, the bonded substrates were subjected to a heat treatment at 150°C for 5 hours to give a joined body.

Subsequently, this joined body was set in a boat and heated to 880°C, as a low temperature heat treatment to the extent that heat peeling does not occur, in a heating furnace. When a mechanical impact was imparted to one end of the ion-implanted region after the heating treatment time for 30 minutes hadpassed, mechanical peeling occurred at the ion-implanted region, whereby a composite substrate in which the single crystal silicon carbide thin film had been homogeneously transferred to the polycrystalline silicon carbide wafer was obtained (the result of the peeling was fine) . In the obtained composite substrate, the major part (by a surface area of about 90%) of the single crystal silicon carbide thin film was peeled from the polycrystalline silicon carbide wafer according to visual observation. Therefore, the composite substrate was in a state that the composite substrate could not be used for the formation of a nanocarbon film form.

### (Comparative Example 1-2)

A composite substrate was prepared in a similar manner to that of Comparative Example 1-1, except that the ion-implanted surface of the single crystal silicon carbide substrate and the surface to be bonded of the handle substrate were subjected to a vacuum ion beam treatment as a surface activation treatment before bonding in Comparative Example 1-1. The vacuum ion beam treatment was conducted by irradiating the surfaces with Ar ion.

As a result, in the obtained composite substrate, the maj or part (by a surface area of about 90%) of the single crystal silicon carbide thin film was peeled from the polycrystalline silicon carbide wafer according to visual observation. Therefore, the composite substrate was in a state that the composite substrate could not be used for the formation of a nanocarbon film form.

### (Comparative Example 1-3)

A composite substrate was prepared in a similar manner to that of Comparative Example 1-1, except that the ion-implanted surface of the single crystal silicon carbide substrate and the surface to be bonded of the handle substrate were subjected to an immersion treatment by ozone water as a surface activation treatment before bonding in Comparative Example 1-1. The immersion treatment by ozone water was conducted by immersing the substrates in a container containing ultrapure water containing ozone for 10 minutes.

As a result, in the obtained composite substrate, the maj or part (by a surface area of about 90%) of the single crystal silicon carbide thin film was peeled from the polycrystalline silicon carbide wafer according to visual observation. Therefore, the composite substrate was in a state that the composite substrate could not be used for the formation of a nanocarbon film form.

### (Comparative Example 1-4)

A composite substrate was prepared in a similar manner to that of Comparative Example 1-1, except that the substrates were not treated, i.e., the surface activation treatment before bonding was not conducted, in Comparative Example 1-1.

As a result, in the obtained composite substrate, the maj or part (by a surface area of about 90%) of the single crystal silicon carbide thin film was peeled from the polycrystalline silicon carbide wafer according to visual observation. Therefore, the composite substrate was in a state that the composite substrate cannot be used for the formation of a nanocarbon film form.

Although the present invention has been explained with referring to the exemplary embodiments, the present invention is not limited to the above-mentioned exemplary embodiments, and can be changed within the scope that can be conceived by a person skilled in the art such as other exemplary embodiments, addition, change and deletion, and either of the embodiments is encompassed in the scope of the present invention as long as the action and effect of the present invention are exerted.

### Reference Signs List

- 1, 1a: Single crystal silicon carbide substrate
- 2: Ion-implanted region
- 3a, 3b: Thin film
- 3: Intermediate layer
- 4: Handle substrate
- 5: Bonded substrate
- 6: Single crystal silicon carbide thin film
- 7, 7': Composite substrate

## Claims

1. A method for manufacturing a composite substrate, comprising:
implanting ion from a surface of a single crystal silicon carbide substrate to form an ion-implanted region;
bonding an ion-implanted surface of the single crystal silicon carbide substrate and a main surface of a handle substrate, and
peeling the single crystal silicon carbide substrate at the ion-implanted region to transfer a single crystal silicon carbide thin film onto the handle substrate,
wherein the surface to be bonded of the single crystal silicon carbide substrate and the surface to be bonded of the handle substrate each has a surface roughness RMS of 1.00 nm or less.

2. The method for manufacturing a composite substrate according to claim 1, wherein the handle substrate is formed of a heat resistant material having a heat resistance temperature of 1, 100°C or more (except for single crystal silicon carbide).

3. The method for manufacturing a composite substrate according to claim 1 or 2, wherein the handle substrate is formed of an amorphous silicon carbide or a polycrystalline silicon carbide.

4. The method for manufacturing a composite substrate according to any one of claims 1 to 3, comprising forming a thin film formed of at least one kind of material selected from silicon oxide, silicon nitride, aluminum oxide, aluminum nitride, zirconiumoxide, silicon and silicon carbide on the ion-implanted surface of the single crystal silicon carbide substrate and/or the main surface of the handle substrate; and polishing the thin film to thereby adjust the surface roughness RMS of the surface of the thin film to 1.00 nm or less.

5. The method for manufacturing a composite substrate according to any one of claims 1 to 3, comprising forming a thin film formed of at least one kind of metal material selected from Ti, Au, Ag, Cu, Ni, Co, Fe, Cr, Zr, Mo, Ta and W on the ion-implanted surface of the single crystal silicon carbide substrate and/or the main surface of the handle substrate; and adjusting the a surface roughness RMS of the surface of the thin film to 1.00 nm or less.

6. The method for manufacturing a composite substrate according to any one of claims 1 to 5, comprising subjecting the surface to be bonded of the silicon carbide substrate and/or the surface to be bonded of the handle substrate to a surface activation treatment, and conducting the bonding.

7. The method for manufacturing a composite substrate according to claim 6, wherein the surface activation treatment is a plasma activation treatment, a vacuum ion beam treatment or an immersion treatment in ozone water.

8. The method for manufacturing a composite substrate according to any one of claims 1 to 7, comprising bonding the single crystal silicon carbide substrate and the handle substrate, and applying a physical impact to the ion-implanted region to thereby peel the single crystal silicon carbide substrate.

9. A composite substrate obtained by the method for manufacturing a composite substrate according to any one of claims 1 to 8.

10. The composite substrate according to claim 9, wherein the composite substrate is for forming a nanocarbon film.
